# EUROPÄISCHE PATENTSCHRIFT

(11) **EP 1 966 836 B1**
(45) Veröffentlichungstag und Bekanntmachung des Hinweises auf die Patenterteilung: **06.02.2019**
(21) Anmeldenummer: 06840869.9
(22) Anmeldetag: 13.12.2006
(51) Int. Cl.: H01L 33/00

(54) **LED-HALBLEITERKÖRPER UND VERWENDUNG EINES LED-HALBLEITERKÖRPERS**
LED SEMICONDUCTOR BODY AND USE OF AN LED SEMICONDUCTOR BODY
CORPS SEMI-CONDUCTEUR DE DEL ET UTILISATION D UN CORPS SEMI-CONDUCTEUR DE DEL

(30) Priorität: 30.12.2005 DE 102005063105; 22.08.2006 DE 102006039369
(43) Veröffentlichungstag der Anmeldung: 10.09.2008
(73) Patentinhaber: OSRAM Opto Semiconductors GmbH, 93055 Regensburg (DE)
(72) Erfinder: WINDISCH, Reiner, 93186 Pettendorf (DE); GRÖNNINGER, Günther, 92358 Seubersdorf (DE); HEIDBORN, Peter, 93197 Zeitlarn (DE); JUNG, Christian, 93188 Pielenhofen (DE); WEGLEITER, Walter, 93152 Nittendorf (DE)
(74) Vertreter: Epping - Hermann - Fischer
(86) Internationale Anmeldenummer: PCT/DE2006/002228
(87) Internationale Veröffentlichungsnummer: WO 2007/076796

(56) Entgegenhaltungen:
- EP-A- 1 475 835
- EP-A- 1 605 561
- WO-A2-2005/073485
- US-A1- 2004 090 779
- US-A1- 2004 206 949
- US-A1- 2005 067 627
- US-A1- 2005 189 551
- US-B1- 6 365 911
- US-B1- 6 620 643

## Beschreibung

Die vorliegende Erfindung betrifft ein LED-Halbleiterkörper sowie ein Bauelement mit einem LED-Halbleiterkörper.

Herkömmliche LED-Halbleiterkörper weisen in der Regel eine Schichtstruktur mit einem pn-Übergang auf. Im Bereich dieses pn-Übergangs befindet sich die aktive Schicht der LED, in der im Betrieb die Strahlungserzeugung stattfindet. Die erzeugte Strahlungsmenge hängt von der Stromstärke ab, mit der der LED-Halbleiterkörper betrieben wird.

Allerdings sollte die Stromdichte in der aktiven Schicht eine vom jeweils verwendeten Materialsystem abhängige maximale Stromdichte nicht überschreiten, da anderenfalls die Gefahr besteht, dass übermäßige Alterungseffekte die Lebensdauer des LED-Halbleiterkörpers nachteilig verkürzen.

LED-Halbleiterkörper mit mehreren aktiven Schichten sind beispielsweise in den Druckschriften US 2005/0067627, WO 2005/073485, US 2005/0189551, US 2004/090779, EP 1605561, US 6620643, US 6365911 und US 2004/206949 beschrieben.

Es ist Aufgabe der vorliegenden Erfindung, einen LED-Halbleiterkörper mit einer erhöhten Strahlungsdichte anzugeben.

Diese Aufgabe wird durch einen LED-Halbleiterkörper gemäß Patentanspruch 1 gelöst.

Vorteilhafte Weiterbildungen der Erfindung sind Gegenstand der abhängigen Ansprüche.

Ein erfindungsgemäßer LED-Halbleiterkörper weist eine erste strahlungserzeugende aktive Schicht und eine zweite strahlungserzeugende aktive Schicht auf, wobei die erste aktive Schicht und die zweite aktive Schicht in vertikaler Richtung übereinander angeordnet sind. Dabei erzeugen die erste und die zweite aktive Schicht Strahlung gleicher Wellenlänge.

Vorteilhafterweise wird so gegenüber herkömmlichen LED-Halbleiterkörpern die Strahlungsmenge und insbesondere die Strahlungsdichte für eine vorgegebene Wellenlänge vorteilhaft erhöht. Weiterhin sind die erste und die zweite aktive Schicht monolithisch in den Halbleiterkörper integriert. Dadurch entfällt der Herstellungsschritt des Verbindens des ersten Schichtstapels mit dem zweiten Schichtstapel, beispielsweise mittels Bonden.

Ferner ist bei dem LED-Halbleiterkörper zwischen der ersten und der zweiten aktiven Schicht eine Verbindungsschicht eines ersten Leitfähigkeitstyps und auf der der Verbindungsschicht abgewandten Seite der ersten und der zweiten aktiven Schicht jeweils eine Schicht eines zweiten Leitfähigkeitstyps angeordnet.

Dabei ist die Verbindungsschicht mittels eines Kontakts elektrisch anschließbar. Dies wird durch eine entsprechende Anordnung und Ausbildung der Verbindungsschicht ermöglicht. Weiterhin sind die außenliegenden Schichten des zweiten Leitfähigkeitstyps mittels einer externen Kontaktierung elektrisch verbunden. Mittels der externen, das heißt außerhalb des Halbleiterkörpers angeordneten Kontaktierung, ist eine elektrische Parallelschaltung der ersten und der zweiten aktiven Schicht möglich.

Die pn-Übergänge der ersten und der zweiten aktiven Schicht sind gegensinnig zueinander ausgebildet, so dass also eine pn-np- bzw. np-pn-Struktur entsteht, wobei die beiden pn-Übergänge mittels einer n-leitenden bzw. p-leitenden Verbindungsschicht verbunden sind. Vorteilhafterweise bleibt mittels einer Parallelschaltung die Vorwärtsspannung gegenüber einer herkömmlichen LED unverändert.

Unter einer aktiven Schicht ist vorliegend ein strahlungserzeugender pn-Übergang zu verstehen. Dieser pn-Übergang kann im einfachsten Fall mittels einer p-leitenden und einer n-leitenden Halbleiterschicht gebildet sein, die unmittelbar aneinandergrenzen. Bevorzugt ist zwischen der p-leitenden und der n-leitenden aktiven Schicht die eigentliche strahlungserzeugende Schicht, etwa in Form einer dotierten oder undotierten Quantenschicht, ausgebildet. Die Quantenschicht kann als Einfachquantentopfstuktur (SQW, Single Quantum Well) oder Mehrfachquantentopfstruktur (MQW, Multiple Quantum Well) oder auch als Quantendraht oder Quantenpunktstruktur ausgeformt sein.

Bei einem erfindungsgemäßen LED-Halbleiterkörper mit übereinander angeordneten aktiven Schichten stehen im Vergleich zu herkömmlichen LED-Halbleiterkörpern der eingangs genannten Art zwei oder auch mehr aktive Schichten gleichzeitig zur Strahlungserzeugung zur Verfügung, so dass die erzeugte Strahlungsmenge insgesamt bzw. die Strahlungsdichte vorteilhaft erhöht ist.

Gegenüber einer anderen Möglichkeit zur Erhöhung der Strahlungsmenge, nämlich der Vergrößerung der Querschnittsfläche des Halbleiterkörpers in lateraler Richtung, zeichnet sich ein LED-Halbleiterkörper mit übereinander gestapelten pn-Übergängen durch einen vorteilhaft verringerten Herstellungsaufwand und damit auch durch geringere Herstellungskosten pro LED-Halbleiterkörper aus. Eine Vergrößerung der Querschnittsfläche des Halbleiterkörpers kann demgegenüber zu deutlich höheren Kosten pro LED-Halbleiterkörper führen.

Unter einem LED-Halbleiterkörper ist vorliegend ein Halbleiterkörper für eine Leuchtdiode, also ein inkohärente Strahlung emittierendes Halbleiterbauelement gemeint, wobei insbesondere die erste und die zweite aktive Schicht jeweils inkohärente Strahlung erzeugen.

Bei einer nicht erfindungsgemäßen Weiterbildung des LED-Halbleiterkörpers ist zwischen der ersten aktiven Schicht und der zweiten aktiven Schicht ein Tunnelübergang ausgebildet. Dieser Tunnelübergang dient als elektrische Verbindung zwischen der ersten und zweiten aktiven Schicht. Beispielsweise kann ein solcher Tunnelübergang mittels einer hochdotierten Schicht eines ersten Leitfähigkeitstyps und einer hochdotierten Schicht eines zweiten Leitfähigkeitstyps gebildet sein. Es sei angemerkt, dass die Halbleiterschichten nicht notwendigerweise homogen dotiert sein müssen, da bereits eine hohe Dotierung an der Grenzfläche zu der jeweils anderen Halbleiterschicht zur Ausbildung eines Tunnelübergangs ausreichen kann.

Vorzugsweise sind bei dieser Weiterbildung die erste und die zweite aktive Schicht gleichsinnig angeordnet, so dass also deren pn-Übergänge eine pn-pn- bzw. np-np-Strukur bilden, wobei die pn-Übergänge mittels des dazwischenliegenden Tunnelübergangs elektrisch in Serie geschaltet sind. Es können im Rahmen der vorliegenden Erfindung in ähnlicher Weise auch drei oder mehr aktive Schichten in einem LED-Halbleiterkörper vertikal übereinander angeordnet sein, die in entsprechender Weise durch jeweils einen zwischen zwei benachbarten aktiven Schichten gebildeten Tunnelübergang verbunden sind.

Ferner ist es möglich, dass der Tunnelübergang aus einer ersten leitfähigen Schicht des ersten Leitfähigkeitstyps und einer zweiten leitfähigen Schicht eines zweiten Leitfähigkeitstyps gebildet ist, wobei zwischen der ersten Schicht und der zweiten Schicht eine Zwischenschicht angeordnet ist, die undotiert oder mit dem ersten oder zweiten Leitfähigkeitstyp niedrig dotiert sein kann.

Außerdem ist es denkbar, dass zwischen der ersten Schicht und der zweiten Schicht zwei Zwischenschichten angeordnet sind, wobei die an die erste Schicht angrenzende Zwischenschicht den gleichen Leitfähigkeitstyp wie die erste Schicht besitzt, und die an die zweite Schicht angrenzende Zwischenschicht den gleichen Leitfähigkeitstyp wie die zweite Schicht besitzt.

Zweckmäßigerweise ist der LED-Halbleiterkörper auf einem Trägerelement angeordnet. Bevorzugt wird hierzu ein elektrisch leitfähiges Trägerelement verwendet. Dies ermöglicht die Ausbildung eines vertikal leitfähigen Bauelements, bei dem der Stromfluss im Wesentlichen in vertikaler Richtung verläuft. Derartige Bauelemente zeichnen sich durch eine vergleichsweise homogene Stromverteilung innerhalb des LED-Halbleiterkörpers aus. Zur Kontaktierung ist zweckmäßigerweise auf einer dem LED-Halbleiterkörper abgewandten Seite des leitfähigen Trägerelements ein Rückseitenkontakt angeordnet.

Alternativ oder zusätzlich kann das Trägerelement für die erzeugte Strahlung durchlässig sein, so dass eine Strahlungsauskopplung durch das Substrat möglich ist.

Der LED-Halbleiterkörper kann auf dem Trägerelement epitaktisch aufgewachsen sein. Das Aufwachssubstrat dient dann zugleich als Trägerelement. Für das epitaktische Aufwachsen können die bekannten und etablierten Epitaxie-Techniken, beispielsweise für das AlGaAs- oder InAlGaAS- Materialsystem, herangezogen werden.

Alternativ ist der LED-Halbleiterkörper auf einem von dem Aufwachssubstrat verschiedenen Trägerelement montiert, wobei bevorzugt das Aufwachssubstrat von dem Halbleiterkörper entfernt worden ist. Dann kann der Halbleiterkörper auch als Dünnfilm-Halbleiterkörper bezeichnet werden.

Ein Dünnfilm-Halbleiterkörper zeichnet sich insbesondere durch mindestens eines der folgenden charakteristischen Merkmale aus:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20µm oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben.

Ein Dünnfilm-Leuchtdioden-Chip ist in guter Näherung ein Lambert' scher Oberflächenstrahler und eignet sich insbesondere für die Anwendung in einem Scheinwerfer.

Bei dem als Dünnfilm-Halbleiterkörper ausgebildeten LED-Halbleiterkörper ist die Intensität ausgekoppelter Strahlung vorteilhaft erhöht.

Je nach Materialsystem kann die Entfernung des Aufwachssubstrats mechanisch, thermisch oder mittels eines Laserabhebeverfahrens erfolgen. Dünnfilm-Halbleiterkörper zeichnen sich durch eine vorteilhafte geringe Vorwärtsspannung und eine hohe Effizienz bei der Strahlungserzeugung aus. Weiterhin sind Dünnfilm-Halbleiterkörper hinsichtlich der Auswahl des Trägerelements nicht durch die für die Epitaxie notwendigen Randbedingungen limitiert, so dass die Trägerelemente beispielsweise hinsichtlich ihrer thermischen Leitfähigkeit oder auch ihrer Kosten optimiert sein können. Dünnfilm-Halbleiterkörper der oben genannten Art eignen sich insbesondere für das InGaAlP- oder InGaAlN-Materialsystem.

Als Halbleitermaterial eignen sich für den LED-Halbleiterkörper und gegebenenfalls für ein Trägerelement, auf dem der Halbleiterkörper angeordnet ist, beispielsweise InAlGaAs (AlₙGaₘIn₁₋ₙ₋ₘAs mit 0 ≤ n ≤ 1, 0 ≤ m ≤ 1 und n+m ≤ 1), InGaAlP (AlₙGaₘIn₁₋ₙ₋ₘP mit 0 ≤ n ≤ 1, 0 ≤ m ≤ 1 und n+m ≤ 1) und/oder InGaAlN (AlₙGaₘIn₁₋ₙ₋ₘN mit 0 ≤ n ≤ 1, 0 ≤ m ≤ 1 und n+m ≤ 1), wobei die jeweiligen binären und ternären Verbindungen wie zum Beispiel GaAs, AlGaAs, GaP, InP, GaAlP, GaN oder InGaN eingeschlossen sind.

Dabei muss das jeweilige Material nicht zwingend eine mathematisch exakte Zusammensetzung nach obiger Formel aufweisen. Vielmehr kann es ein oder mehrere Dotierstoffe sowie zusätzliche Bestandteile aufweisen, die die physikalischen Eigenschaften des Materials im Wesentlichen nicht ändern. Der Einfachheit halber beinhaltet obige Formel jedoch nur die wesentlichen Bestandteile des Kristallgitters (Al, Ga, In, P), auch wenn diese teilweise durch geringe Mengen weiterer Stoffe ersetzt sein können.

Vorzugsweise emittiert der LED-Halbleiterkörper im Betrieb Strahlung in vertikaler Richtung, wobei die von der ersten und zweiten aktiven Schicht emittierte Strahlung typischerweise durchmischt ist.

Ein LED-Halbleiterkörper mit übereinander angeordneten aktiven Schichten kann zur Allgemeinbeleuchtung verwendet werden. Durch die erhöhte Strahlungsdichte ist ein derartiger Halbleiterkörper dafür besonders geeignet.

Desweiteren kann der LED-Halbleiterkörper zur Hinterleuchtung, beispielsweise von Displays, verwendet werden.

Vorzugsweise wird der LED-Halbleiterkörper für Projektionsanwendungen verwendet.

Weitere Merkmale, Vorzüge und Zweckmäßigkeiten der Erfindung ergeben sich aus den in Verbindung mit den Figuren 2 bis 4 nachfolgend beschriebenen Ausführungsbeispiele.

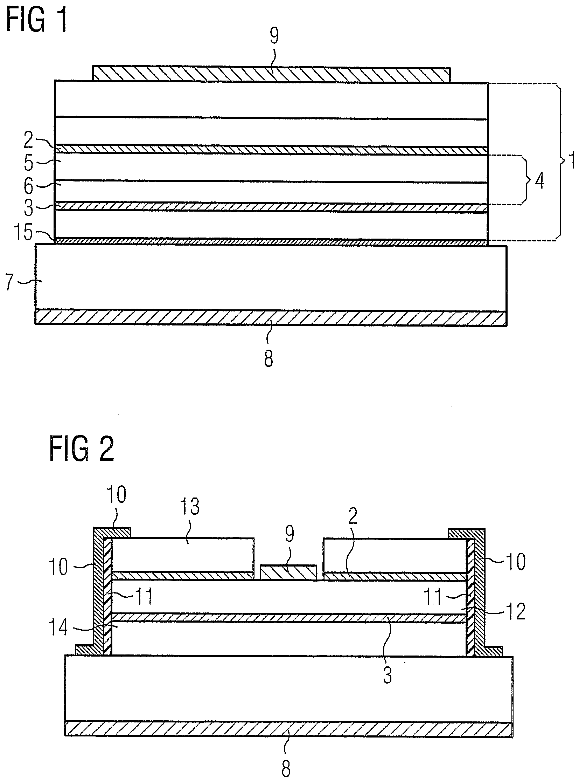

Figur 1 betrifft ein nicht erfindungsgemäßen Beispiel. Es zeigen:
Figur 1 eine schematische Schnittansicht eines nicht erfindungsgemäßen Bespiels eines LED-Halbleiterkörpers,
Figur 2 eine schematische Schnittansicht eines erfindungsgemäßen Ausführungsbeispiels eines LED-Halbleiterkörpers,
Figur 3 ein Schaubild darstellend Strom/Leistungs-Kennlinien zweier im sichtbaren Bereich abstrahlender LED-Halbleiterkörper gemäß der Erfindung,
Figur 4 ein Schaubild darstellend Strom/Leistungs-Kennlinien zweier im infraroten Bereich abstrahlender LED-Halbleiterkörper gemäß der Erfindung.

Gleiche oder gleichwirkende Elemente sind in den Figuren mit den selben Bezugszeichen versehen.

Der in Figur 1 dargestellte LED-Halbleiterkörper 1 eines nicht erfindungsgemäßen Beispiels weist eine erste strahlungserzeugende aktive Schicht 2 und eine zweite strahlungserzeugende aktive Schicht 3 auf, wobei die aktiven Schichten in vertikaler Richtung, das heißt senkrecht zu einer Haupterstreckungsrichtung der aktiven Schichten übereinander angeordnet sind. Zwischen den aktiven Schichten 2, 3 ist ein Tunnelübergang 4 ausgebildet, der mittels einer ersten Halbleiterschicht 5 eines ersten Leitfähigkeitstyps, beispielsweise einer n-leitenden Halbleiterschicht, und einer zweiten Halbleiterschicht 6 eines zweiten Leitfähigkeitstyps, beispielsweise einer p-leitenden Halbleiterschicht gebildet ist. Vorzugsweise sind diese beiden Halbleiterschichten 5, 6 hochdotiert ausgeführt, so dass im Betrieb ein effizienter Tunnelübergang mit einem geringen elektrischen Übergangswiderstand entsteht.

Durch die Anordnung zweier aktiver Schichten in einem LED-Halbleiterkörper wird vorteilhafterweise die insgesamt erzeugte Strahlungsmenge erhöht. Da sich die Abmessungen des LED-Halbleiterkörpers gegenüber einem LED-Halbleiterkörper mit nur einer einzigen aktiven Schicht nur unmaßgeblich ändern und insbesondere der Querschnitt des LED-Halbleiterkörpers von der Zahl der aktiven Schichten unabhängig ist, wird weitergehend auch die Strahlungsdichte vorteilhaft erhöht.

Der Halbleiterkörper 1 ist auf einem Trägerelement 7 angeordnet. Eine dem Trägerelement 7 zugewandte Oberfläche des Halbleiterkörpers 1 ist bevorzugter Weise mit einer reflektierenden Schicht 15 versehen. Besonders bevorzugt sind sowohl die reflektierende Schicht 15 als auch das Trägerelement 7 elektrisch leitend. Weitergehend ist das Trägerelement 7 auf einer dem Halbleiterkörper 1 abgewandten Seite mit einem Rückseitenkontakt 8 versehen. Entsprechend ist auf einer dem Trägerelement 7 gegenüberliegenden Seite des LED-Halbleiterkörpers 1 ein Vorderseitenkontakt 9 ausgebildet. Somit wird ein vertikal leitfähiges Bauelement gebildet, das sich durch eine vergleichsweise homogene Stromverteilung innerhalb des LED-Halbleiterkörpers auszeichnet.

Der LED-Halbleiterkörper 1 wird auf einem gesonderten Aufwachssubstrat aufgewachsen und nachfolgend auf das Trägerelement montiert, bespielsweise mittels Löten, Bonden oder Kleben, wobei vorzugsweise das Aufwachssubstrat von dem LED-Halbleiterkörper abgelöst ist. Die reflektierende Schicht 15 kann beispielsweise als ein Bragg-Spiegel, eine metallische Schicht, eine TCO-Schicht (Transparent Conductive Oxide) wie beispielsweise eine ITO- oder ZnO-schicht oder ein Verbund einer metallischen Schicht und einer TCO-Schicht ausgebildet sein. Strahlungsanteile, die in Richtung des Trägerelements 7 emittiert werden, können somit in Richtung der Strahlungsauskoppelseite zurück reflektiert werden.

Auf der Strahlungsauskopplungsseite kann der LED-Halbleiterkörper zur Erhöhung der Strahlungsausbeute mit einer Aufrauhung, einer Oberflächenstrukturierung, etwa in Form von Mikroprismen, oder einem anderen Mittel zur Reduzierung von (Total-)reflexionsverlusten an der Strahlungsauskoppelfläche versehen sein.

Das in Figur 2 dargestellte erfindungsgemäße Ausführungsbeispiel zeigt einen LED-Halbleiterkörper 1, der wie das nicht erfindungsgemäße Beispiel gemäß Figur 1 eine erste strahlungserzeugende aktive Schicht 2 und eine zweite strahlungserzeugende aktive Schicht 3 aufweist und auf einem Trägerelement 7 angeordnet ist, welches mit einem Rückseitenkontakt 8 versehen ist.

Im Unterschied zu dem nicht erfindungsgemäßen Beispiel gemäß Figur 1 ist zwischen der ersten aktiven Schicht 2 und der zweiten aktiven 3 Schicht eine Verbindungsschicht 12 eines ersten Leitfähigkeitstyps, beispielsweise eine p-leitende Halbleiterschicht angeordnet. Die Ausbildung eines Tunnelübergangs ist hierbei nicht zwingend erforderlich. Auf der dieser Verbindungsschicht 12 abgewandten Seite der ersten aktiven Schicht 2 und der zweiten aktiven Schicht 3 ist jeweils eine Halbleiterschicht 13, 14 eines zweiten Leitfähigkeitstyps, beispielsweise eine n-leitende Halbleiterschicht gebildet. Im Unterschied zu dem nicht erfindungsgemäßen Beispiel gemäß Figur 1 sind bei dem LED-Halbleiterkörper gemäß Figur 2 somit die pn-Übergänge der aktiven Schichten 2 und 3 gegensinnig angeordnet, so dass eine np-pn-Struktur entsteht.

Selbstverständlich können im Rahmen der Erfindung sämtliche Leitfähigkeitstypen miteinander vertauscht werden, so dass beispielsweise bei dem Ausführungsbeispiel gemäß Figur 2 die Verbindungsschicht 12 n-leitend und die außenliegenden Schichten 13, 14 p-leitend sind und somit eine pn-np-Struktur entsteht.

Zur Kontaktierung ist in der oberseitigen Halbleiterschicht 13 des zweiten Leitfähigkeitstyps, beispielsweise der n-leitenden Halbleiterschicht, eine Ausnehmung gebildet, die bis zur Verbindungsschicht 12 reicht. Innerhalb dieser Ausnehmung ist ein Vorderseitenkontakt 9 angeordnet, über den die Verbindungsschicht 12 elektrisch anschließbar ist.

Die hinsichtlich der Verbindungsschicht 12 außenliegenden Halbleiterschichten 13, 14 des zweiten Leitfähigkeitstyps sind über eine externe Verbindung 10, beispielsweise eine Metallisierung oder eine elektrisch leitfähige TCO-Beschichtung, und das Trägerelement 7 elektrisch leitend miteinander und mit dem Rückseitenkontakt 8 verbunden.

Zwischen der externen Verbindung 10 und dem Halbleiterkörper 1 ist eine Isolierschicht 11 vorgesehen. Hiermit kann verhindert werden, dass die externe Verbindung 10 die aktive Schichten 2 und 3 elektrisch kurzschließt.

Der Halbleiterkörper 1 ist auf das Trägerelement 7 aufgewachsen.

Auf der Strahlungsauskopplungsseite kann der LED-Halbleiterkörper wiederum zur Erhöhung der Strahlungsausbeute mit einer Aufrauhung, einer Oberflächenstrukturierung, etwa in Form von Mikroprismen, oder einem anderen Mittel zur Reduzierung von (Total-)reflexionsverlusten an der Strahlungsauskoppelfläche versehen sein.

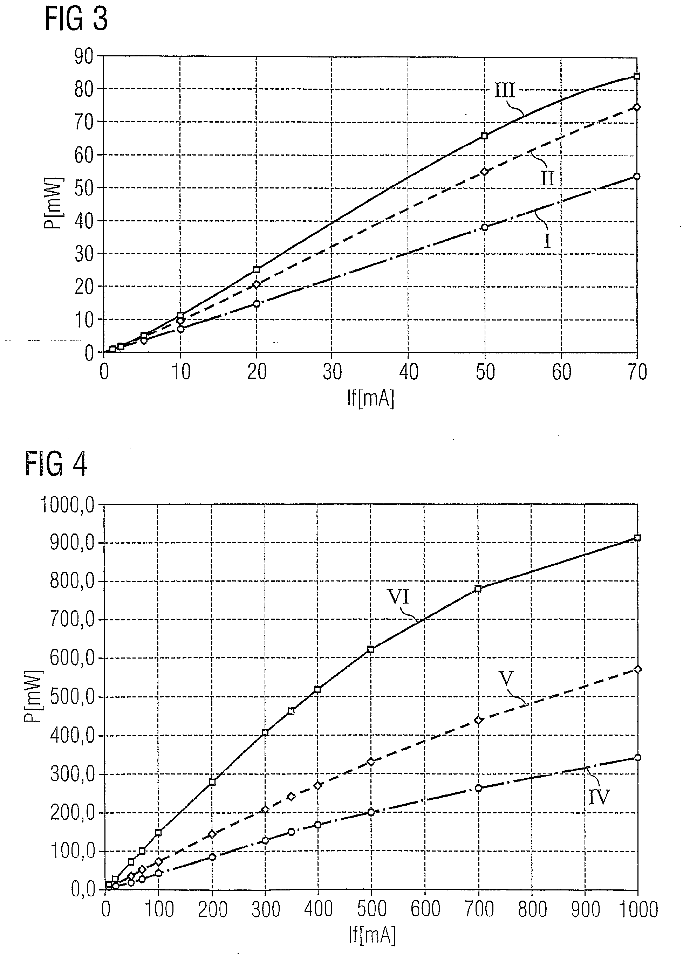

In Figur 3 sind Kennlinien I, II und III eines ersten, zweiten und dritten LED-Halbleiterkörpers dargestellt. Die Halbleiterkörper unterscheiden sich in der Anzahl der aktiven Schichten voneinander. Der die Kennlinie I aufweisende erste Halbleiterkörper umfasst eine aktive Schicht. Der die Kennlinie II aufweisende zweite Halbleiterkörper umfasst zwei aktive Schichten, zwischen denen ein Tunnelübergang angeordnet ist. Der die Kennlinie III aufweisende dritte Halbleiterkörper umfasst drei aktive Schichten, wobei zwischen zwei aktiven Schichten jeweils ein Tunnelübergang angeordnet ist.

Die Halbleiterkörper enthalten InGaAlP und emittieren Strahlung im sichtbaren Bereich, vorzugsweise mit einer Wellenlänge λ = 630 nm.

Aus dem Schaubild geht hervor, dass die Strahlungsleistung P der Halbleiterkörper mit zunehmender Stromstärke If des zugeführten Stroms ansteigt. Ferner ist zu sehen, dass der dritte Halbleiterkörper, zumindest im Bereich If > 10 mA, bei gleicher Stromstärke eine größere Strahlungsleistung aufweist als der erste und der zweite Halbleiterkörper. Da die Halbleiterkörper eine etwa identische Größe aufweisen, ist somit die Strahlungsdichte beim dritten Halbleiterkörper am größten. Weiterhin ist die Strahlungsdichte des zweiten Halbleiterkörpers größer als die Strahlungsdichte des ersten Halbleiterkörpers, der als Referenz dient.

In Figur 4 sind Kennlinien IV, V und VI eines ersten, zweiten und dritten LED-Halbleiterkörpers dargestellt. Die Halbleiterkörper unterscheiden sich in der Anzahl der aktiven Schichten voneinander. Der die Kennlinie IV aufweisende erste Halbleiterkörper umfasst eine aktive Schicht. Der die Kennlinie V aufweisende zweite Halbleiterkörper umfasst zwei aktive Schichten, zwischen denen ein Tunnelübergang angeordnet ist. Der die Kennlinie VI aufweisende dritte Halbleiterkörper umfasst fünf aktive Schichten, wobei zwischen zwei aktiven Schichten jeweils ein Tunnelübergang angeordnet ist.

Die Halbleiterkörper emittieren Strahlung im infraroten Bereich, insbesondere mit einer Wellenlänge λ = 950 nm. Bevorzugter Weise umfasst die aktive Schicht einen GaAs/AlGaAs-Heteroübergang. Besonders bevorzugt sind die Halbleiterkörper als Dünnfilm-Halbleiterkörper ausgebildet. Weiterhin sind die Halbleiterkörper Hochstrom-Halbleiterkörper.

Entsprechend der Figur 3 geht aus dem in Figur 4 dargestellten Schaubild hervor, dass die Strahlungsleistung P der Halbleiterkörper mit zunehmender Stromstärke If des zugeführten Stroms ansteigt. Ferner ist zu sehen, dass der dritte Halbleiterkörper, zumindest im Bereich If > 50 mA, bei gleicher Stromstärke eine größere Strahlungsleistung aufweist als der erste und der zweite Halbleiterkörper. Da die Halbleiterkörper eine etwa identische Größe aufweisen, ist somit die Strahlungsdichte beim dritten Halbleiterkörper am größten. Weiterhin ist die Strahlungsdichte des zweiten Halbleiterkörpers größer als die Strahlungsdichte des ersten Halbleiterkörpers.

Die Erfindung ist nicht durch die Beschreibung anhand der Ausführungsbeispiele beschränkt. Insbesondere können im Rahmen der Erfindung nicht nur zwei aktive strahlungserzeugende Schichten, sondern auch drei, vier oder mehr strahlungserzeugende Schichten vertikal übereinander angeordnet sein, die bevorzugt jeweils mittels einer Verbindungsschicht elekrisch miteinander verbunden sind.

## Patentansprüche

1. LED-Halbleiterkörper mit einer ersten strahlungserzeugenden aktiven Schicht (2) und einer zweiten strahlungserzeugenden aktiven Schicht (3), wobei:
- die erste aktive Schicht und die zweite aktive Schicht in vertikaler Richtung übereinander angeordnet sind,
- die erste aktive Schicht und die zweite aktive Schicht in dem Halbleiterkörper monolithisch integriert sind,
- die erste aktive Schicht und die zweite aktive Schicht Strahlung gleicher Wellenlänge erzeugen,
- zwischen der ersten und der zweiten aktiven Schicht eine Verbindungsschicht (12) eines ersten Leitfähigkeitstyps angeordnet ist, und auf der der Verbindungsschicht abgewandten Seite der ersten und der zweiten aktiven Schicht jeweils eine Schicht (13, 14) eines zweiten Leitfähigkeitstyps angeordnet ist,
- die Verbindungsschicht mittels eines Kontakts (9) elektrisch anschließbar ist, und
- die außenliegenden Schichten des zweiten Leitfähigkeitstyps mittels einer externen Kontaktierung (10) elektrisch verbunden sind.

2. LED-Halbleiterkörper nach Anspruch 1, wobei die erste und die zweite aktive Schicht (2, 3) jeweils inkohärente Strahlung erzeugen.

3. LED-Halbleiterkörper nach einem der vorhergehenden Ansprüche, wobei der Halbleiterkörper, vorzugsweise eine der beiden aktiven Schichten (2, 3) oder beide aktive Schichten, InGaAlN, InGaAlAs oder InGaAlP enthalten.

4. LED-Halbleiterkörper nach einem der vorhergehenden Ansprüche, wobei der Halbleiterkörper in vertikaler Richtung Strahlung emittiert.

5. Bauelement mit einem LED-Halbleiterkörper nach einem der vorhergehenden Ansprüche und einem Trägerelement (7), wobei der LED-Halbleiterkörper auf dem Trägerelement, das vorzugsweise elektrisch leitfähig und/oder für die erzeugte Strahlung durchlässig ist, angeordnet ist.

6. Bauelement nach Anspruch 5, wobei der LED-Halbleiterkörper auf dem Trägerelement (7) aufgewachsen ist.

7. Bauelement nach einem der Ansprüche 5 oder 6, wobei der LED-Halbleiterkörper auf einem von dem Trägerelement (7) verschiedenen Aufwachssubstrat aufgewachsen ist.

8. Bauelement nach Anspruch 7, wobei das Aufwachssubstrat von dem Halbleiterkörper entfernt ist.

## Claims

1. LED semiconductor body comprising a first radiation-generating active layer (2) and a second radiation-generating active layer (3) wherein:
- the first active layer and the second active layer are arranged one above another in vertical direction,
- the first and the second active layer are monolithically integrated in the semiconductor body,
- the first and the second active layer generate radiation having a similar wavelength,
- a connecting layer (12) of a first conductivity type is arranged between the first and the second active layer, and a layer (13, 14) of a second conductivity type is in each case arranged on that side of the first and of the second active layer which is remote from the connecting layer,
- the connecting layer is electrically connectable by means of a contact (9), and
- the outer layers of the second conductivity type are electrically connected by means of an external contact-connection (10).

2. LED semiconductor body according to claim 1, the first and the second active layer (2, 3) in each case generating incoherent radiation.

3. LED semiconductor body according to one of the preceding claims, the semiconductor body, preferably one of the two active layers (2, 3) or both active layers, containing InGaAlN, InGaAlAs or InGaAlP.

4. LED semiconductor body according to one of the preceding claims, the semiconductor body emitting radiation in the vertical direction.

5. Component with a LED semiconductor body according to one of the preceding claims and a carrier element (7) wherein the LED semiconductor body is arranged on the carrier element, which is preferably electrically conductive and/or transmissive to the radiation generated.

6. Component according to claim 5, wherein the LED semiconductor body is grown on the carrier element.

7. Component according to one of claims 5 or 6, wherein the LED semiconductor body is grown on a growth substrate which is different from the carrier element (7).

8. Component according to claim 7, wherein the growth substrate is removed from the semiconductor body.

## Revendications

1. Corps semi-conducteur de DEL doté d'une première couche active émettrice de rayonnement (2) et d'une deuxième couche active émettrice de rayonnement (3), dans lequel :
- la première couche active et la deuxième couche active sont agencées l'une au-dessus de l'autre dans le sens vertical,
- la première couche active et la deuxième couche active sont intégrées de manière monolithique dans le corps semi-conducteur,
- la première couche active et la deuxième couche active émettent un rayonnement de même longueur d'onde,
- entre la première et la deuxième couche active est agencée une couche de liaison (12) d'un premier type de conductivité, et sur le côté de la première et de la deuxième couche active opposé à la couche de liaison est agencée respectivement une couche d'un deuxième type de conductivité (13, 14),
- la couche de liaison est susceptible d'être raccordée électriquement au moyen d'un contact (9), et
- les couches extérieures du deuxième type de conductivité sont reliées électriquement au moyen d'une mise en contact externe (10).

2. Corps semi-conducteur de DEL selon la revendication 1, dans lequel la première et la deuxième couche active (2, 3) émettent chacune un rayonnement incohérent.

3. Corps semi-conducteur de DEL selon l'une quelconque des revendications précédentes, dans lequel le corps semi-conducteur, de préférence une des deux couches actives (2, 3) ou les deux couches actives contiennent InGaAlN, InGaAlAs ou InGaAlP.

4. Corps semi-conducteur de DEL selon l'une quelconque des revendications précédentes, dans lequel le corps semi-conducteur émet un rayonnement dans le sens vertical.

5. Composant doté d'un corps semi-conducteur de DEL selon l'une quelconque des revendications précédentes et d'un élément porteur (7), dans lequel le corps semi-conducteur de DEL est agencé sur l'élément porteur qui est de préférence électroconducteur et/ou perméable au rayonnement émis.

6. Composant selon la revendication 5, dans lequel le corps semi-conducteur de DEL est déposé sur l'élément porteur (7).

7. Composant selon l'une quelconque des revendications 5 ou 6, dans lequel le corps semi-conducteur de DEL est déposé sur un substrat de croissance différent de l'élément porteur (7).

8. Composant selon la revendication 7, dans lequel le substrat de croissance est retiré du corps semi-conducteur.
